# EUROPEAN PATENT APPLICATION

(11) **EP 4 557 447 A1**
(43) Date of publication of application: **21.05.2025**
(21) Application number: 24194351.3
(22) Date of filing: 13.08.2024
(51) Int. Cl.: H01M 10/42, H01M 50/284

(54) **WIRELESS BATTERY MANAGEMENT SYSTEM AND BATTERY PACK INCLUDING THE SAME**

(30) Priority: 17.11.2023 KR 20230159791
(71) Applicant: SAMSUNG SDI CO., LTD., Giheung-gu Yongin-si, Gyeonggi-do 17084 (KR)
(72) Inventor: HWANG, Yusik, 17084 Yongin-si (KR)
(74) Representative: Marks & Clerk LLP

(57) **Abstract**

A wireless battery management system and a battery pack including the same may be provided. The wireless battery management system may include, a main board on which an integrated circuit that detects status data of a plurality of battery cells is disposed; and an antenna board on which an antenna that wirelessly transmits status data of the plurality of battery cells is disposed, the antenna board being combined to the main board at a predetermined angle.

## Description

### BACKGROUND

### (a) Field

This disclosure relates to a wireless battery management system and a battery pack including the same.

### (b) Description of the Related Art

Recently, wireless battery management system (BMS) technology has been attracting attention in constructing a battery pack for electric vehicle.

The wireless BMS may eliminate wiring and a plurality of harnesses that require high maintenance costs, accordingly, the volume of the battery pack may be reduced, the weight of the electric vehicle may be reduced, and vehicle efficiency may be increased. However, according to the environmental characteristics within the vehicle, the temperature may increase and electromagnetic noise may increase, and electromagnetic waves generated by the wireless BMS may affect nearby integrated circuits. Therefore, measures for electromagnetic wave shielding by wireless BMS are needed.

### SUMMARY

At least one of the embodiments may provide a wireless battery management system that minimizes transmission of electromagnetic wave signals generated by an antenna to an integrated circuit and a battery pack including the same.

According to one embodiment, a wireless battery management system is provided. The wireless battery management system includes a main board on which an integrated circuit that is configured to detect status data of a plurality of battery cells is disposed; and an antenna board on which an antenna that is configured to wirelessly transmit status data of the plurality of battery cells is disposed, the antenna board being combined to the main board at a predetermined angle.

The wireless battery management system may further include a guide member comprising a first part combined to an edge of the main board, and a second part extending at the predetermined angle to the first part and combined to the antenna board.

The wireless battery management system may further include a bonding layer disposed between one surface of the second part and the antenna board.

The first part may include a first extension part combined to a first edge of the main board, and extending along a first direction; and a second extension part combined to a second edge different from the first edge of the main board, and extending along a second direction different from the first direction.

The wireless battery management system may further include a flexible printed circuit board (FPCB) connecting between the integrated circuit and the antenna.

The FPCB may pass through the second part.

The FPCB may surround at least part of the second part.

The predetermined angle may be greater than 0 degrees and less than 180 degrees.

According to another embodiment, a battery pack is provided. The battery pack includes a plurality of battery cells; and a battery management system comprising a main board on which an integrated circuit that is configured to detect status data of a plurality of battery cells is disposed, and an antenna board combined to the main board at a predetermined angle and on which an antenna that is configured to wirelessly transmit status data of the plurality of battery cells is disposed.

The battery management system may further include a guide member comprising a first part combined to an edge of the main board, and a second part extending at the predetermined angle to the first part and combined to the antenna board.

The battery management system may further include a bonding layer disposed between one surface of the second part and the antenna board.

The battery management system may further include a flexible printed circuit board (FPCB) connecting between the integrated circuit and the antenna.

The predetermined angle may be greater than 0 degrees and less than 180 degrees.

At least some of the above and other features of the invention are set out in the claims.

### BRIEF DESCRIPTION OF THE DRAWINGS

FIG. 1 is a diagram schematically showing a battery pack according to an embodiment.
FIG. 2 is a diagram showing the slave BMS shown in FIG. 1.
FIG. 3 is a schematic front view of an antenna board according to one embodiment.
FIG. 4 is a front view showing the location of the antenna board in the slave BMS according to one embodiment.
FIG. 5 is a plan view showing the location of the antenna board in the slave BMS according to one embodiment.
FIG. 6 is a view showing a first portion of the guide member shown in FIGS. 4 and 5.

### DETAILED DESCRIPTION OF THE EMBODIMENTS

Example embodiments will now be described more fully hereinafter with reference to the accompanying drawings; however, they may be embodied in different forms and should not be construed as limited to the embodiments set forth herein. Rather, these embodiments are provided so that this disclosure will be thorough and complete, and will fully convey example implementations to those skilled in the art. The drawings and description are to be regarded as illustrative in nature and not restrictive. Like reference numerals designate like elements throughout the specification. In the flowchart described with reference to the drawings in this specification, the order of operations may be changed, several operations may be merged, some operations may be divided, and specific operations may not be performed.

Throughout the specification and claims, if a part is referred to "include" a certain element, it may mean that it may further include other elements rather than exclude other elements, unless specifically indicated otherwise.

In addition, expressions described in the singular may be interpreted in the singular or plural unless explicit expressions such as "one" or "single" are used.

In addition, terms including an ordinal number, such as first, second, etc., may be used to describe various elements, but the elements are not limited by the terms. The above terms are used only for the purpose of distinguishing one element from another element. For example, without departing from the scope of the present disclosure, a first element may be referred to as a second element, and similarly, a second element may be referred to as a first element.

Furthermore, if a component is referred to be "connected" with another component, it includes not only the case where two components are "directly connected" but also the case where two components are "indirectly or non-contactedly connected" with another component interposed therebetween, or the case where two components are "electrically connected." On the other hand, if an element is referred to as "directly connected" to another element, it should be understood that no other element exists in the middle.

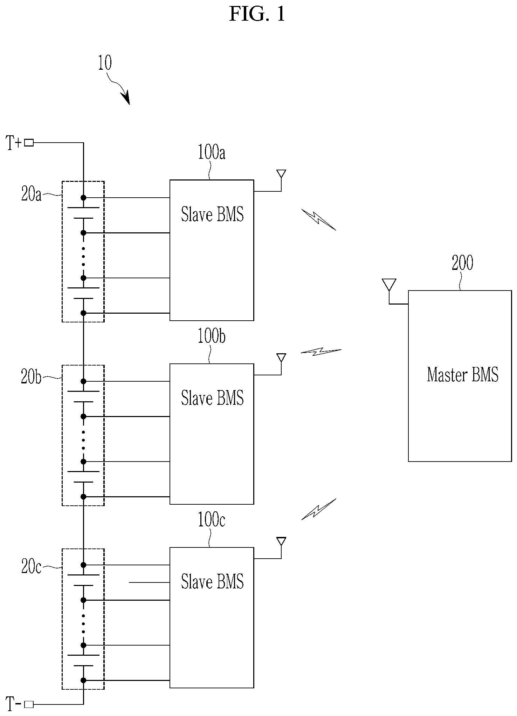

FIG. 1 is a diagram schematically showing a battery pack according to an embodiment.

Referring to FIG. 1, the battery pack 10 may be mounted on various power devices that use the electrical energy stored in the battery pack 10, such as an electric vehicle.

The battery pack 10 may include a plurality of battery modules 20a, 20b, and 20c connected in series with each other, a plurality of slave battery management systems (BMS) 100a, 100b, and 100c, and a master BMS 200. For convenience of explanation, FIG. 1 shows three battery modules 20a, 20b, and 20c in the battery pack 10. Embodiments according to the present disclosure are not limited thereto, however, and embodiments according to the present disclosure may include any suitable number of battery modules according to the design of the battery pack 10.

The plurality of battery modules 20a, 20b, and 20c may be connected to a charging device or load through the system terminals T+, and T-, and may be charged by the charging device or discharged by the load.

The battery modules 20a, 20b, and 20c may each include a plurality of battery cells electrically connected in series and/or parallel.

The plurality of slave BMSs 100a, 100b, and 100c may correspond to the plurality of battery modules 20a, 20b, and 20c included in the battery pack 10.

Each of the plurality of slave BMSs 100a, 100b, and 100c may be electrically connected to the corresponding battery module 20a, 20b, and 20c. For example, the slave BMS 100a may be electrically connected to the battery module 20a, the slave BMS 100b may be electrically connected to the battery module 20b, and the slave BMS 100c may be electrically connected to the battery module 20c.

Each of the plurality of slave BMSs 100a, 100b, and 100c may detect overall status of the battery modules 20a, 20b, and 20c and may perform various control functions to adjust the status of the battery modules 20a, 20b, and 20c. The status may include cell voltage, module voltage, module current and temperature, etc., and control functions may include charging, discharging, balancing, etc. The control functions may be performed directly by the slave BMS 100a, 100b, and 100c based on the status of the battery modules 20a, 20b, and 20c or may be performed according to commands from the master BMS 200.

The master BMS 200 may be connected to a plurality of slave BMSs 100a, 100b, and 100c using a wireless network as a connection method.

The master BMS 200 may receive status information of the battery modules 20a, 20b, and 20c from a plurality of slave BMSs 100a, 100b, and 100c and may perform control functions such as state of charge (SOC), power control, cell balancing control, fault diagnosis control, cooling control and thermal runaway detection control. In addition, the master BMS 200 may control a relay for supplying or blocking power of the battery modules 20a, 20b, and 20c to the load based on information on the battery modules 20a, 20b, and 20c.

Through wireless connection between the master BMS 200 and the plurality of slave BMSs 100a, 100b, and 100c, communication wiring complexity may be reduced, the volume of the battery pack 10 may be reduced, and cost of the battery pack 10 may also be reduced.

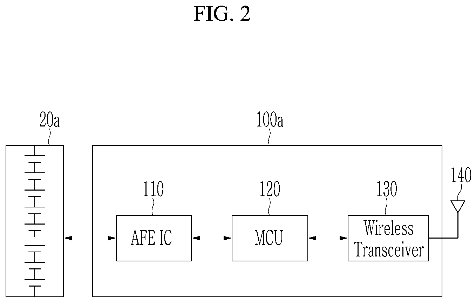

FIG. 2 is a diagram showing the slave BMS shown in FIG. 1.

Referring to FIG. 2, the slave BMS 100a may include an analog front end (AFE) integrated circuit (IC) 110, an MCU 120, a wireless transceiver 130, and an antenna 140. Although the slave BMS 100a is shown in FIG. 2 for convenience, the slave BMSs 100b and 100c may also be configured the same or similar to the slave BMS 100a.

The AFE IC 110 may measure physical state information such as voltage, current, and temperature of the battery module 20a, and control charging and discharging and/or balancing of the battery module 20a. The AFE IC 110 may transmit the measured status information of the battery module 20a to the MCU 120.

The MCU 120 may control the operation of the AFE IC 110. The MCU 120 may transmit status information of the battery module 20a to the wireless transceiver 130. In addition, the MCU 120 may receive a control signal of the master BMS 200 from the wireless transceiver 130, and may control or command the AFE IC 110 according to the control signal of the master BMS 200, and may transmit the control signal of the master BMS 200 to the AFE IC 110.

The wireless transceiver 130 may perform wireless signal processing on the status information of the battery module 20a so that the status information of the battery module 20a may be transmitted through the antenna 140. Additionally, the wireless transceiver 130 may perform signal processing on the control signal of the master BMS 200 received through the antenna 140 and transmit it to the MCU 120. Since the wireless transceiver 130 directly may transmit to the antenna 140 and directly may receive signals from the antenna 140, the wireless transceiver 130 may perform signal amplification and frequency conversion processing through a power amplifier or low-noise amplifier.

In general, a main board (not shown in FIG. 2) of the slave BMS 100a may be mounted on a battery case surrounding the battery module 20a. The AFE IC 110, MCU 120, wireless transceiver 130, and antenna 140 of the slave BMS 100a may be disposed on the main board. In some embodiments, AFE IC 110 and antenna 140 may be disposed on the same surface of the main board. The AFE IC 110 and the antenna 140 may be placed adjacent to each other.

Meanwhile, in the wireless BMS structure, electromagnetic waves may be generated by signal transmission and reception between the antenna 140 of the slave BMS 100a and the antenna of the master BMS 200. As the AFE IC 110 and the antenna 140 are disposed on the same surface of the main board, these electromagnetic waves may affect the AFE IC 110 and the AFE ICs of the surrounding slave BMSs 100b and 100c, and the measurement errors in the AFE IC 110 may occur.

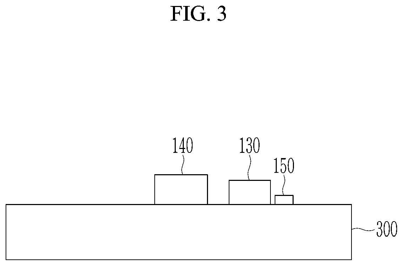

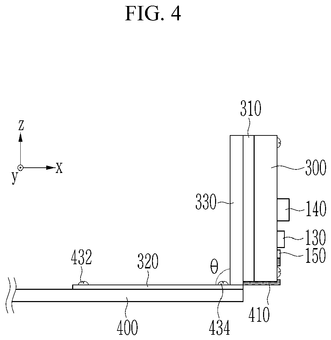

According to an embodiment, in order to reduce electromagnetic waves' influence caused by signal transmission and signal reception of the antenna 140 to the AFE IC 110, the antenna 140 may be mounted on a separate antenna board. That is, the main board on which the AFE IC 110 and the MCU 120 are disposed and the antenna board on which the antenna 140 is disposed may be separate and independent boards with each other. According to the embodiment, the AFE IC 110 and the antenna 140 may be not disposed on the same board, so that the signals from the antenna 140 do not affect the AFE IC 110 mounted on the main board. In addition, according to the embodiment, by providing a member to block electromagnetic waves on the antenna board, it is possible to prevent the signals from the antenna 140 from being transmitted to the main board. This embodiment will be described in detail with reference to FIGS. 3 and 4.

FIG. 3 is a schematic front view of an antenna board according to one embodiment.

Referring to FIG. 3, the antenna 140 and the wireless transceiver 130 may be disposed on one surface of the antenna board 300. In FIG. 3, for convenience of explanation, the wireless transceiver 130 is shown as one block. However, various elements constituting the wireless transceiver 130 may exist, and various elements may be disposed on the antenna board 300.

Additionally, a connector 150 for connection to the MCU 120 disposed on the main board may be disposed on the antenna board 300.

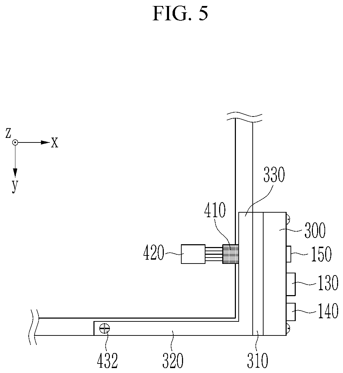

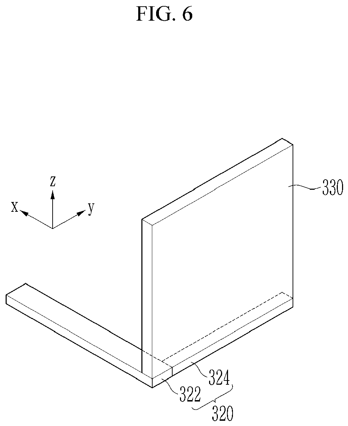

FIG. 4 is a front view showing the location of the antenna board in the slave BMS according to one embodiment, and FIG. 5 is a plan view showing the location of the antenna board in the slave BMS according to one embodiment. FIG. 6 is a view showing a first portion of the guide member shown in FIGS. 4 and 5.

Referring to FIG. 4, the main board 400 and the antenna board 300 may form a predetermined angle θ between each other. For example, one surface of the main board 400 and the other surface of the antenna board 300 adjacent to the one surface of the main board 400 may form a predetermined angle θ to each other. A guide member may be combined to an edge of the main board 400 so that the antenna board 300 may be combined to the main board 400 at a predetermined angle θ.

A first part 320 of the guide member may be combined to the edge of the main board 400, and the second part 330 of the guide member may extend in the z-axis direction. The second part 330 may be a plate-shaped member parallel to the YZ plane that extends at a predetermined angle θ to the first part 320. Here, the predetermined angle θ may be greater than 0 degrees and less than 180 degrees.

In some embodiments, as shown in FIG. 6, the first part 320 may a first extension part 322 and a second extension part 324. The first extension part 322 may be combined to a first edge of the main board 400, and may extend in the X-axis direction. The second extension part 324 may be combined to a second edge of the main board 400, and may extend in the Y-axis direction. Since the second part 330 is a plate-shaped member parallel to the YZ plane, the first part 320 may extend in the X-axis direction and the Y-axis direction and be combined to the main board 400 to reduce the impact in the X-axis direction. The first part 320 may be combined to the edge of the main board 400 through coupling elements 432 and 434.

One surface of the second part 330 combined to the main board 400 may be combined to the other surface of the antenna board 300 through the bonding layer 310. The bonding layer 310 may be a layer containing an adhesive. That is, the other surface of the antenna board 300 may be parallel to the YZ plane. In some embodiments, an electromagnetic wave blocking layer (not shown) may be combined to the other surface of the antenna board 300, and the electromagnetic wave blocking layer may be combined to the second part 330. The electromagnetic wave blocking layer may include a ferrite material.

The connector 150 disposed on one surface of the antenna board 300 may transmit and receive signals with the MCU 120 disposed on the main board 400 through a flexible printed circuit board (FPCB) 410. In some embodiments, one connector terminal of the FPCB 410 may be connected to the connector 150 and the other connector terminal may be connected to the connector 420 connected to the MCU 120. For example, the FPCB 410 may extend from the main board 400 through the second part 330 and extend along a side surface of the antenna board 300 to be disposed on one surface of the antenna board 300. As another example, the FPCB 410 may extend along a side surface of the antenna board 300 to at least partially surround the second part 330 from the main board 400 and may be disposed on one surface of the antenna board 300.

In this way, the antenna 140 may be disposed on one surface of the antenna board 300, and the second part 330 may be combined to the other surface of the antenna board 300, so that the second part 330 and the antenna board 300 may reflect signals of the antenna 140 transmitted to the other surface of the antenna board 300, and accordingly, the signals of the antenna 140 may not be transmitted to the AFE IC 110 disposed on the main board 400. In addition, as the electromagnetic wave blocking layer may be combined to the antenna board 300, signals from the antenna 140 may not be transmitted to the main board 400.

According to at least one of the embodiments, the electromagnetic wave influence caused by the wireless BMS may be reduced.

Although the embodiments of the present disclosure have been described in detail above, the scope of the present disclosure is not limited thereto, and various modifications and improvements of those skilled in the art using the basic concepts of the present disclosure defined in the following claims are also included in the present disclosure.

### <Description of symbols>

10: Battery pack
100a, 100b, 100c: Slave BMS
110: AFE IC
120: MCU
130: Wireless transceiver
140: Antenna
200: Master BMS

## Claims

1. A wireless battery management system comprising:
a main board on which an integrated circuit that is configured to detect status data of a plurality of battery cells is disposed; and
an antenna board on which an antenna that is configured to wirelessly transmit status data of the plurality of battery cells is disposed, the antenna board being combined to the main board at a predetermined angle.

2. The wireless battery management system as claimed in claim 1, further comprising
a guide member comprising a first part combined to an edge of the main board, and a second part extending at the predetermined angle to the first part and combined to the antenna board.

3. The wireless battery management system as claimed in claim 2, further comprising
a bonding layer disposed between one surface of the second part and the antenna board.

4. The wireless battery management system as claimed in claim 2 or 3, wherein
the first part comprises:
a first extension part combined to a first edge of the main board, and extending along a first direction; and
a second extension part combined to a second edge different from the first edge of the main board, and extending along a second direction different from the first direction.

5. The wireless battery management system as claimed in any preceding claim, further comprising
a flexible printed circuit board (FPCB) connecting between the integrated circuit and the antenna.

6. The wireless battery management system as claimed in claim 5 when dependent on claim 2, 3 or 4, wherein
the FPCB passes through the second part.

7. The wireless battery management system as claimed in claim 5 when dependent on claim 2, 3 or 4, wherein
the FPCB surrounds at least part of the second part.

8. The wireless battery management system as claimed in any preceding claim, wherein
the predetermined angle is greater than 0 degrees and less than 180 degrees.

9. A battery pack comprising:
a plurality of battery cells; and
the wireless battery management system as claimed in any preceding claim.
